Europäisches Patentamt

European Patent Office

Office européen des brevets

(11) Veröffentlichungsnummer: **0 287 166 B1**

(12) **EUROPÄISCHE PATENTSCHRIFT**

(45) Veröffentlichungstag der Patentschrift: **08.07.92**

(51) Int. Cl.⁵: **H03K 17/08**

(21) Anmeldenummer: **88200682.8**

(22) Anmeldetag: **11.04.88**

(54) Schaltungsanordnung zur Begrenzung der Einschaltstromspitzen bei einem Schalttransistor.

(30) Priorität: **15.04.87 DE 3712784**

(43) Veröffentlichungstag der Anmeldung:
**19.10.88 Patentblatt 88/42**

(45) Bekanntmachung des Hinweises auf die
Patenterteilung:
**08.07.92 Patentblatt 92/28**

(84) Benannte Vertragsstaaten:
**DE FR GB NL**

(56) Entgegenhaltungen:
**DE-A- 3 247 707**
**DE-A- 3 518 913**
**US-A- 3 930 170**
**US-A- 4 639 823**

**PATENT ABSTRACTS OF JAPAN, Band 10,
Nr. 221 (E-424)[2277], 2. August 1986 & JP-
A-61 58 306**

**ELECTRONIC ENGINEERS, Band 50, Nr. 602,
Februar 1978, Seite 23; A.J. KLIJN:
"Transistor protection for switching power
supplies"**

(73) Patentinhaber: **Philips Patentverwaltung
GmbH
Wendenstrasse 35 Postfach 10 51 49
W-2000 Hamburg 1(DE)**

(84) Benannte Vertragsstaaten:
**DE**

(73) Patentinhaber: **N.V. Philips' Gloeilampenfabrieken
Groenewoudseweg 1
NL-5621 BA Eindhoven(NL)**

(84) Benannte Vertragsstaaten:
**FR GB NL**

(72) Erfinder: **Herrmann, Dieter, Dipl.-Ing.
Oberer Bahnhofstrasse 34
W-8541 Büchenbach(DE)**

(74) Vertreter: **Peuckert, Hermann, Dipl.-Ing. et al
Philips Patentverwaltung GmbH Wendenstrasse 35 Postfach 10 51 49
W-2000 Hamburg 1(DE)**

**Beschreibung**

Die Erfindung betrifft eine Schaltungsanordnung zur Begrenzung der Einschaltstromspitzen bei einem Schalttransistor, an dessen Steuereingang rechteckförmige Schaltimpulse gleicher Höhe gelegt werden, mit in einer Anschlußleitung des Schalttransistors liegenden Spule, durch die der Arbeitsstrom des Schalttransistors fließt, wobei die durch Selbstinduktion in dieser Spule erzeugte Spannung der Steuerspannung des Schalttransistors entgegenwirkt und die Selbstinduktion der Spule so bemessen ist, daß das Auftreten von Einschaltstromspitzen zu einer wirksamen Reduktion der Steuerspannung des Schalttransistors führt.

Eine Schaltanordnung dieser Art ist aus US-A-4,639,823 bekannt. Sie enthält einen Schalttransistor mit Emitter, Basis und Kollektor. Dabei liegt in Reihe zum Emitter des Schalttransistors eine Spule, wobei antiparallel zur Basis-Emitter-Strecke und der Spule eine Vielzahl von Dioden eingeschaltet sind. Die in der Spule induzierte Spannung beim Abfallen des Spulenstromes infolge eines Abschaltens des Schalttransistors wird an die Basis des Schalttransistors geliefert.

Eine andere Schaltanordnung ist z.B. aus der Patentanmeldung DE-A-35 18 913 bekannt. Der Schalttransistor - ein Feldeffekt-Transistor - liegt bei der bekannten Anordnung im Primärkreis eines getakteten Gleichspannungswandlers. Ein Pulsbreitenmodulator steuert die Einschaltzeiten des Feldeffekt-Transistors dadurch, daß er zwischen Gate- und Source-Anschluß des Transistors rechteckförmige Schaltimpulse anlegt, die in der Länge variieren. In Serie zur Kontaktstrecke des Schalttransistors, nämlich in der Drain-Zuführungsleitung, liegt eine sättigbare Drossel, mit der die Einschaltstromspitzen begrenzt werden.

Wird der Transistor leitend geschaltet, fällt ohne die sättigbare Drossel die gesamte Eingangsspannung über seiner Drain-Source-Strecke ab; hohe Stromspitzen (8A und mehr) und daher hohe Verlustleistungen im Transistor sind die Folge, die auch zu seiner Zerstörung führen können. Die Drossel begrenzt die Stromspitzen und geht dabei in die Sättigung, so daß das weitere Verhalten des Wandlers während eines Schaltimpulses von ihr nicht beeinflußt wird.

Da die Drossel jedoch im Arbeitskreis des Transistors liegt, fällt zu den Einschaltzeitpunkten des Transistors an ihr eine Spannungsdifferenz von der Größenordnung der Eingangsspannung des Gleichspannungswandlers ab. Die Drossel muß also so dimensioniert sein, daß sie vorübergehende Spannungsdifferenzen von der angedeuteten Größenordnung ohne Schaden übersteht. Je nach Anwendungsfall kann die Eingangsspannung eines Gleichspannungswandlers bei einigen Volt oder bei einigen hundert Volt liegen. Daher ist die bekannte Schutzschaltung für jeden Anwendungsfall neu zu dimensionieren, soll sie nicht unnötig überdimensioniert sein.

Der Erfindung liegt die Aufgabe zugrunde, eine Schaltungsanordnung der eingangs genannten Art anzugeben, die geringe Verluste aufweist und insbesondere für einen Gleichspannungswandler mit einer hoher Leistungsübertragung geeignet ist.

Diese Aufgabe wird bei einer Schaltungsanordnung der eingangs genannten Art dadurch gelöst, daß die Spule die Primärspule eines Stromwandlers ist, in dessen Sekundärkreis eine Gleichrichterdiode liegt und als Last ein erster Widerstand geschaltet ist, dem die Serienschaltung aus einer sättigbaren Drossel und einem zweiten Lastwiderstand parallel geschaltet ist, wobei der Widerstandswert des ersten Lastwiderstandes etwa um einen Faktor 100 größer ist als der Widerstandswert des zweiten Lastwiderstandes.

Bei der erfindungsgemäßen Anordnung der Spule braucht sie keinen magnetisch sättigbaren Kern zu haben. Die maximalen Spannungsdifferenzen, die zwischen ihren Anschlüssen auftreten können, sind so groß wie die Höhe der Schaltimpulse für den Schalttransistor; sie ist entsprechend dieser Belastung in ihrem magnetischen Querschnitt und ihrer Windungszahl zu dimensionieren. Die Windungszahl kann in allen Anwendungsfällen so klein gewählt werden, daß die Wicklungskapazität der Spule praktisch null ist.

Vorteilhafte Ausgestaltungen der Erfindung sind den Unteransprüchen zu entnehmen. In der Erfindung wird eine Schaltungsanordnung angegeben, mit der der Betriebsstrom durch den Schalttransistor eines getakteten Gleichspannungswandlers überwacht wird. Bei Gleichspannungswandlern mit hoher Leistungsübertragung hat sie den Vorteil, daß geringere Verluste auftreten als bei Überwachungsschaltungen, bei denen der Betriebsstrom durch einen ohmschen Meßwiderstand fließt.

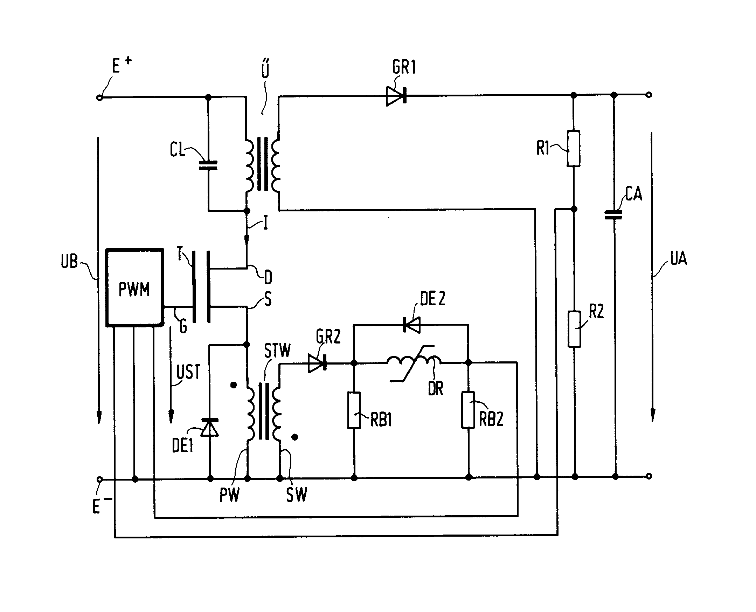

Anhand der Figur und eines Ausführungsbeispiels soll die Erfindung näher erläutert werden.

Die Figur zeigt die Prinzipschaltung eines getakteten Gleichspannungswandlers, in dem die Erfindung verwendet wird.

Im Primärkreis des Gleichspannungswandlers, an dessen Eingang $E^+$, $E^-$ eine Eingangsspannung UB anliegt, befindet sich die Parallelschaltung einer Kapazität CL und der Primärspule eines Übertragers Ü sowie die Kontaktstrecke eines Feldeffekt-Transistors T, dessen Drain-Anschluß D mit der Parallelschaltung verbunden ist und dessen Source-Anschluß S über eine weitere Spule PW mit dem negativen Pol $E^-$ der Eingangsspannungsquelle in Verbindung steht. Parallel zur Spule PW ist in Sperrichtung eine Entmagnetisierungsdiode DE1 gelegt. Ein Pulsbreitenmodulator PWM versorgt den Feldeffekt-Transistor T mit Steuerimpulsen UST. Die Steuerspannung UST fällt zwischen dem Gate-Anschluß G und dem negativen Pol E⁻ der Primärspannungsquelle ab. Ist der Transistor T geöffnet, beträgt die Steuerspannung UST 15 Volt, ist er geschlossen beträgt sie null Volt. Die Kapazität CL ist die auf die Primärseite übersetzte Wicklungskapazität des Übertragers Ü. Im Sekundärkreis des Übertragers Ü, der gleichzeitig der Ausgangskreis des Gleichspannungswandlers ist, liegt eine erste Gleichrichterdiode GR1 und ein Ausgangskondensator CA, an dem eine Ausgangsspannung UA abfällt. Parallel zum Kondensator CA liegt ein Spannungsteiler R1, R2, dessen Mittenabgriff mit einem Eingang des Pulsbreitenmodulators PWM verbunden ist.

Ist der Transistor T gesperrt, fällt die gesamte Eingangsspannung UB zwischen seinem Drain- und seinem Source-Anschluß ab. Wird er geöffnet, wirkt die Kapazität CL zum Einschaltzeitpunkt wie ein Kurzschluß, so daß die Spannung UB nun zwischen dem Drain-Anschluß D und dem negativen Pol E⁻ der Eingangsspannungsquelle anliegt, also über der Serienschaltung der niederohmigen Drain-Source-Strecke des Transistors T und der Spule PW abfällt.

Ein schneller Anstieg des Stromes I wird durch die Spule PW, die keinen sättigbaren Kern zu haben braucht, nun auch dadurch verhindert, daß sie die Gate-Source-Spannung des Transistors T bis auf nahezu null Volt erniedrigt. Auf diese Weise wird der Stromfluß durch den Transistor T so gesteuert, daß an den Enden der Spule PW niemals eine Spannungsdifferenz auftreten kann, die größer als 15 Volt ist. Ihre Induktivität ist lediglich so zu bemessen, daß der Transistor T im Betriebsbereich des Stromes I leitend bleibt. Die in der Einschaltstromspitze des Stromes I enthaltene Energie ist in der Spule PW als magnetische Energie gespeichert und wird dann, wenn der Strom I abklingt, über die Entmagnetisierungsdiode DE1 in Wärme umgewandelt.

Bei der bisherigen Erläuterung ist unberücksichtigt geblieben, daß die Spule PW Primärspule eines Stromwandlers STW ist. Für die Einschaltvorgänge ist diese Tatsache bedeutungslos, da die Sekundärspule des Stromwandlers STW - wie weiter unten noch ausführlicher dargelegt wird - so hochohmig beschaltet ist, daß die Rückwirkung des Sekundärkreises auf den Primärkreis des Stromwandlers STW praktisch vernachlässigbar ist.

Der Sekundärkreis des Stromwandlers STW hat den Zweck, über den Pulsbreitenmodulator PWM die Einschaltzeit des Transistors T dann sofort zu verkürzen, wenn der (mit etwa konstanter Änderungsgeschwindigkeit) ansteigende Strom I einen kritischen Wert überschreitet; unbeeinflußt soll der Pulsbreitenmodulator von den oben beschriebenen Vorgängen zum Einschaltzeitpunkt bleiben.

Aus diesem Grunde ist zwischen die Anschlüsse der Sekundärspule SW des Stromwandlers STW die Serienschaltung einer zweiten Gleichrichterdiode GR2 und eines ersten Lastwiderstandes RB1 (Bürde) geschaltet; parallel zum ersten Lastwiderstand RB1 liegt die Serienschaltung einer Drossel DR und eines zweiten Lastwiderstandes RB2. Die Drossel DR ist durch eine zweite Entmagnetisierungsdiode DE2 überbrückt. Die Ausgangsanschlüsse des Sekundärkreises stimmen mit den Anschlüssen des zweiten Lastwiderstandes RB2 überein. Die zwischen diesen Anschlüssen liegende Spannung ist an die Anschlüsse zur Stromüberwachung des Pulsbreitenmodulators PMW gelegt, der in vorliegendem Beispiel der integrierte Baustein UC1846 von SGS ist. Die Drossel DR ist sättigbar, d.h., ihr Kern ist aus einem Material gefertigt, das zu Betriebsbedingungen in die magnetische Sättigung gerät.

Wird nun der Transistor T leitend geschaltet, fällt über den Anschlüssen der Sekundärwicklung SW bzw. über dem Lastwiderstand RB1 eine Spannung ab, die anfänglich eine bei Null beginnende Spitze hat und dann monoton auf einen Grenzwert ansteigt. Der Widerstandswert des Lastwiderstandes RB1 ist so gewählt, daß sich der Zeitverlauf der über ihm abfallenden Spannung weitgehend analog zum Zeitverlauf des Stroms I im Primärkreis des Gleichspannungswandlers verhält. Diese Analogie wird dazu ausgenutzt, die Einschaltzeiten des Transistors T sofort zu verkürzen, wenn die Spannung über dem Lastwiderstand RB1, abgesehen von der Spitze, einen kritischen Wert überschreitet. Hierzu dient der Spannungsteiler aus der sättigbaren Drossel DR und dem zweiten Lastwiderstand RB2, dessen Widerstandswert etwa im hundertstel des Widerstandswertes des ersten Lastwiderstandes RB1 beträgt. Der über diesen Spannungsteiler fließende Strom steigt mit der Spannung über dem Lastwiderstand RB1, abgesehen von einer Stromspitze, die durch die Drossel DR verhindert wird. Hat der Strom durch die Drossel DR eine von der Dimensionierung der Drossel DR abhängige Schwelle überschritten, gerät sie in die magnetische Sättigung. Dieser Vorgang führt zu einem schnelleren Stromanstieg durch die Drossel DR und damit zu einem schnelleren Spannungsanstieg über den Widerstand RB2. Die Drossel DR wirkt also wie ein stromabhängiger Widerstand; ist sie nicht gesättigt, ist die Gesamtlast, die an die Sekundärspule SW geschaltet ist, gering, ist sie gesättigt, wird die Last vergrößert. Die vergrößerte Gesamtlast führt dazu, daß auf der Primärseite des Stromwandlers STW nur noch seine Streuinduktivität wirksam ist. Das ist besonders dann für die Dimensionierung der Induktivität der Primärspule PS von Vorteil, wenn hohe Betriebsströme fließen können. Wächst nun der Strom I weiter an, so tut das auch der Strom durch den Lastwiderstand RB2 und damit die Spannung, die über ihm abfällt. Liegt diese Spannung schließlich über einer am Pulsbreitenmodulator PWM einstellbaren Schwelle, wird der Transistor T sofort bis zum Auftreten des nächsten Schaltimpulses gesperrt.

Wie schon angedeutet, ist bei der Bemessung der Widerstände RB1 und RB2 darauf zu achten, daß der Widerstandswert des Widerstandes RB1 wesentlich größer ist (etwa um einen Faktor 100) als der des Widerstandes RB2. Außerdem muß der Widerstandswert des Widerstandes RB1 auch groß sein gegen den ohmschen Widerstand der Wicklungen PW und SW, damit die oben gegebenen Erläuterungen zur Wirkung der Spule PW gültig sind. Bei 15 Volt für die Spannung UST läßt sich der Stromwandler STW so auslegen, daß der Widerstand RB1 einige hundert Ohm beträgt und der Widerstand RB2 einige Ohm.

## Patentansprüche

1. Schaltungsanordnung zur Begrenzung der Einschaltstromspitzen bei einem Schalttransistor, an dessen Steuereingang rechteckförmige Schaltimpulse gleicher Höhe gelegt werden, mit in einer Anschlußleitung des Schalttransistors (T) liegenden Spule (PW), durch die der Arbeitsstrom des Schalttransistors fließt, wobei die durch Selbstinduktion in dieser Spule (PW) erzeugte Spannung der Steuerspannung des Schalttransistors (T) entgegenwirkt und daß die Selbstinduktivität der Spule (PW) so bemessen ist, daß das Auftreten von Einschaltstromspitzen zu einer wirksamen Reduktion der Steuerspannung des Schalttransistors (T) führt, dadurch gekennzeichnet, daß die Spule (PW) die Primärspule eines Stromwandlers (STW) ist, in dessen Sekundärkreis eine Gleichrichterdiode (GR2) liegt und als Last ein erster Widerstand (RB1) geschaltet ist, dem die Serienschaltung aus einer sättigbaren Drossel (DR) und einem zweiten Lastwiderstand (RB2) parallel geschaltet ist, wobei der Widerstandswert des ersten Lastwiderstandes (RB1) etwa um einen Faktor 100 größer ist als der Widerstandswert des zweiten Lastwiderstandes (RB2).

2. Schaltungsanordnung nach Anspruch 1, dadurch gekennzeichnet, daß der Spule (PW) eine erste Entmagnetisierungs-Diode (DE1) parallel geschaltet ist.

3. Schaltungsanordnung nach einem der Ansprüche 1 oder 2, dadurch gekennzeichnet, daß parallel zur sättigbaren Drossel (DR) eine zweite Entmagnetisierungs-Diode (DE2) liegt.

## Claims

1. A circuit arrangement for limiting the switch-on current surges in a switching transistor whose control input receives rectangular switching pulses of the same height, comprising a coil (PW) which is connected in a connection lead of the switching transistor (T) and wherethrough the operating current of the transistor flows, the voltage produced in said coil (PW) by self-induction counteracting the control voltage of the switching transistor (T) and the self-induction of the coil (PW) being proportioned so that the appearance of switch-on current surges lads to an effective reduction of the control voltage of the switching transistor (T), characterized in that the coil (PW) is the primary coil of a current transformer (STW) whose secondary circuit includes a rectifier diode (GR2) and a load in the form of a first resistor (RB1) with which the series connection of a saturable choke (DR) and a second load resistor (RB2) is connected in parallel, the resistance value of the first load resistor (RB1) being approximately a factor 100 greater than the resistance value of the second load resistor (RB2).

2. A circuit arrangement as claimed in Claim 1, characterized in that a first demagnetization diode (DE1) is connected parallel to the coil (PW).

3. A circuit arrangement as claimed in Claim 1 or 2, characterized in that a second demagnetization diode (DE2) is connected parallel to the saturable choke (DR).

## Revendications

1. Circuit de limitation des pointes de courant dues à la mise en circuit pour un transistor commutateur (T) à l'entrée de commande duquel sont appliquées des impulsions de commutation rectangulaires de hauteur égale et dans une ligne de raccordement duquel est disposée une bobine (PW) traversée par le courant de fonctionnement du transistor commutateur, la tension engendrée par auto-induction dans cette bobine (PW) contrecarrant la tension de commande du transistor commutateur (T) et l'inductance de la bobine (PW) étant dimensionnée de façon que l'apparition de pointes de courant dues à la mise en circuit provoque une réduction efficace de la tension de commande du transistor commutateur (T), caractérisé en ce que la bobine (PW) est la bobine primaire d'un transformateur de courant (STW) dont le circuit secondaire comporte une diode redresseuse (GR2) et, comme charge, une première résistance (RB1) en parallèle avec laquelle est disposé le montage série d'une bobine d'arrêt saturable (DR) et d'une seconde résistance de charge (RB2), la valeur ohmique de la première résistance de charge (RB1) étant supérieure d'un facteur 100 environ à la valeur ohmique de la seconde résistance de charge (RB2).

2. Circuit selon la revendication 1, caractérisé en ce qu'en parallèle avec la bobine (PW), est connectée une première diode de démagnétisation (DE1).

3. Circuit selon l'une des revendications 1 et 2, caractérisé en ce qu'en parallèle avec la bobine saturable (DR), est connectée une seconde diode de démagnétisation (DE2).